# EUROPEAN PATENT APPLICATION

(11) **EP 4 372 792 A1**
(43) Date of publication of application: **22.05.2024**
(21) Application number: 22207894.1
(22) Date of filing: 16.11.2022
(51) Int. Cl.: H01L 21/761, H01L 21/74

(54) **SEMICONDUCTOR DEVICE**

(71) Applicant: Infineon Technologies Dresden GmbH & Co . KG, 01099 Dresden (DE)
(72) Inventor: HIRLER, Franz, 84424 Isen (DE); WEIS, Rolf, 01109 Dresden (DE); FUCHS, Cornelius, 01689 Weinböhla (DE); MAHMOUD, Ahmed, 85354 Freising (DE)
(74) Representative: JENSEN & SON

(57) **Abstract**

In an embodiment, a semiconductor device comprises a semiconductor substrate of a first conductivity type which comprises a first surface. A first device region is formed in the semiconductor substrate and has the first conductivity type. The first device region has a lateral extent that is less than the lateral extent of the first surface of the semiconductor substrate. The first device region is electrically separated from the semiconductor substrate by an isolation structure. The isolation structure comprises a buried layer which is doped with a second conductivity type that opposes the first conductivity type and further comprises a first elongate sinker of the second conductivity type. The first elongate sinker extends from the first surface into the semiconductor substrate and is in electrical contact with the buried layer. The semiconductor device further comprises a breakdown voltage influencing structure of the second conductivity type that is arranged in the semiconductor substrate and laterally adjacent the buried layer.

## Description

### BACKGROUND

To date, transistors used in power electronic applications have typically been fabricated with silicon (Si) semiconductor materials. Common transistor devices for power applications include Si CoolMOS^{®}, Si Power MOSFETs, and Si Insulated Gate Bipolar Transistors (IGBTs).

In some applications, two or more semiconductor devices are integrated within a common semiconductor substrate. Depending on the application, it may be desirable to electrically isolate one of the devices from the semiconductor substrate and from the other devices in the semiconductor substrate. US 2019/098666 A1 discloses a device including a depletion mode MOSFET device and an embedded diode. The embedded diode is junction isolated by an isolation region located between the anode of the diode and the source of the MOSFET.

Improvements to a semiconductor device including two or more devices integrated in a common semiconductor substrate are desirable.

### SUMMARY

According to the invention, a semiconductor device is provided which comprises a semiconductor substrate of a first conductivity type which comprises a first major surface. A first device region is formed in the semiconductor substrate and has the first conductivity type. The first device region has a lateral extent that is less than the lateral extent of the first surface of the semiconductor substrate. The first device region is electrically separated from the semiconductor substrate by an isolation structure. The isolation structure comprises a buried layer which is doped with a second conductivity type that opposes the first conductivity type and further comprises a first elongate sinker of the second conductivity type. The first elongate sinker extends from the first surface into the semiconductor substrate and is in electrical contact with the buried layer. The semiconductor device further comprises a breakdown voltage influencing structure of the second conductivity type that is arranged in the semiconductor substrate and laterally adjacent the buried layer.

The semiconductor device includes a first device area formed in the semiconductor substrate that is electrically separated from the remainder of the semiconductor substrate by an isolation structure. The remainder of the semiconductor substrate can provide one or more further device areas. The first device area occupies a minor portion of the first major surface, i.e. less than 50% of the area of the first major surface. The isolation structure comprises the opposing conductivity type to the conductivity type of the semiconductor substrate and the first device area and comprises a buried layer and first sinker both comprising material of the second conductivity type. The buried layer is positioned within the volume of the semiconductor substrate and is spaced apart from the first major surface and also from the opposing second major surface of the semiconductor substrate. The buried layer vertically insulates the first device region from the underlying portion of the semiconductor substrate. The doped first elongate sinker electrically contacts the buried layer and provides lateral insulation of the first device region for the semiconductor substrate.

The breakdown voltage influencing structure comprises the second conductivity type and is positioned in the semiconductor substrate laterally adjacent the buried layer and laterally outside of the first device area. The breakdown voltage influencing structure serves to increase the breakdown potential of the insulation structure with respect to the substrate. Thus, the isolation strength of the semiconductor device is improved.

The breakdown voltage influencing structure may have different forms. For example, the breakdown influencing structure may comprise a buried region that is doped with the second conductivity type and/or a second elongate sinker that comprises the second conductivity type. In some embodiments, the breakdown voltage influencing structure is an integral part of the first elongate sinker.

The buried layer and the first sinker are fabricated using masks having an open area through which the dopants are implanted into the semiconductor substrate. For example, a first mask for the buried layer may have a substantially square or rectangular opening defined by a continuous edge. The second mask for the sinker may comprise a ring-shaped opening. The masks are designed such that in the aligned state the ring-shaped opening in the second mask is positioned vertically above and overlaps with the opening in the first mask for the buried layer. The open areas of both masks, i.e. implant mask of buried layer and the trench mask of the first sinker may be designed to overlap, e.g. to have the same outer opening edge.

To optimize both the first sinker contact resistance and the breakdown voltage, in some embodiments a smaller spacing between the second sinker and the edge of the buried layer is selected for the long side to reduce the sinker contact resistance and a larger spacing is selected at the corners to increase the corner breakdown voltage The spacings can be selected so that the breakdown voltage at both the corners and the straight sides is similar or as similar as possible.

In some embodiments, the breakdown voltage influencing structure comprises a second sinker of the second conductivity type that extends from the first surface into the semiconductor substrate. The second sinker is arranged laterally adjacent the buried layer. In some embodiments, the second sinker is laterally spaced apart from the buried layer by a portion of the semiconductor substrate.

The buried layer has a lateral extent. The second sinker is arranged laterally outside of the area of the buried layer and of the first device area whereas the first sinker is arranged laterally inside or within the area of the buried layer.

The lateral extent of the buried layer and the first and second sinkers is determined in part by the masks used to form the respective structures. The relative arrangement of the buried layer and the first and second sinkers described herein corresponds to the relative arrangement of the respective masks of the buried layer and the first and second sinkers.

The first elongate sinker may have a continuous ring-shape which laterally and continuously surrounds the first device region. The first elongate sinker may be in contact with the buried layer along its entire length or may be in contact with the buried layer at one or more discrete regions in order to electrically contact the elongate first sinker to the buried layer and electrically separate the first device region from the semiconductor substrate.

In order to reduce the parasitic pnp gain, a second sinker can be provided at the corners. The inner first sinker connects the buried layer at a position with a higher BL-concentration (higher base concentration for lower gain). The outer second sinker provides a higher breakdown voltage and shields the inner sinker form high fields. The two sinkers can form T-shape connections or one sinker can end in close proximity to the other resulting in a high concentration of the overlapping outdiffused profiles. Two or more circumferential continuous sinkers may also be used.

The second sinker may be electrically floating or connected to a voltage supply which has a lower potential than the first device region.in case of n-doped buried layer (BL) and p-doped substrate. In the case of p-doped (BL) and n-doped substrate the second sinker may be electrically floating or connected to a voltage supply which has a higher potential than the first device region.

In some embodiments, a second sinker is added with a spacing from the edge of the buried layer. This spacing refers to the space between the edge of the opening in the mask for the buried layer and the edge of the opening in the mask for the second sinker. The spacing can be adjusted to achieve a particular breakdown voltage. For example, in one set of simulation conditions a breakdown voltage of around 165V observed in a comparison without a floating second sinker decreases with increasing spacing before it increases and peaks at 192V.

In some embodiments, the sinkers are fabricated by predeposition of doped BSG/PSG into trenches formed in the first major surface followed by a rather short outdiffusion. The low temperature budget for the outdiffusion results in a steep doping concentration gradient which is much steeper than the doping gradient for the buried layer.

In some embodiments, the breakdown voltage influencing structure comprises at least one buried region of the second conductivity type that is arranged laterally adjacent the buried layer. The buried region is, in some embodiments, spaced apart from the buried layer by a portion of the semiconductor substrate. The buried region is arranged laterally outboard of the lateral extent of the buried layer and is arranged in the semiconductor substrate laterally adjacent and laterally outside the first device region.

In some embodiments, the buried layer has a polygonal form in plan view with at least three corners. One buried region is arranged laterally adjacent one of the corners of the buried layer. In some embodiments, one buried layer is arranged laterally adjacent each of the corners of the buried layer. Typically, the buried layer has a square or rectangular form and has four corners and one buried region is arranged laterally adjacent each of the corners so that four discrete buried regions are provided. The buried layer mask at the corners may be rounded or chamfered or may comprise a polygon. After outdiffusion a typical rounding radius may be attributed to the buried layer region.

The breakdown voltage is also a function of curvature radius so that the curvature radius at corners reduces the breakdown voltage further. Therefore, the corners of the buried layer have a lower breakdown voltage compared to stripe geometry, i.e. the straight sides extending between the corners. The breakdown influencing structure can, therefore, be different at the corners compared to the regions extending between the corners. Due to the reduced breakdown voltage at the typically rounded corners of the buried layer, in some embodiments, the breakdown voltage influencing structure is arranged only near the corners in order to locally increase the breakdown voltage in the corner region.

In some embodiments, the breakdown voltage influencing structure comprises a second sinker of the second conductivity type and at least one buried region of the second conductivity type. In some embodiments, the buried region overlaps the second sinker. The second sinker extends from the first major surface into the semiconductor substrate and has a base that overlaps and may be positioned in the buried region.

In one set of simulation conditions a breakdown voltage of around 165V observed in a comparison without a floating second sinker decreases with increasing spacing before it increases and peaks at 192V. The use of a floating buried layer in place of the second sinker allows for breakdown voltages up to 206V. A combination of the floating buried layer connected to a sinker allows even higher breakdown voltages.

In some embodiments, one or more second sinkers regions or buried regions are provided outside the isolation structure. The sinker and/or buried regions may have an elongate form, a ring-form, or a bubble form. The sinker and/or buried region may be electrically floating or connected to a voltage supply at a lower potential than the first device region for an n-doped buried region and/or sinker and p-doped substrate. For a p-doped buried region and/or sinker and an n-doped substrate, the sinker and/or buried region may be electrically floating or connected to a voltage supply at a higher potential than the first device region. The floating buried region can form a closed ring structure around the first device region.

In some embodiments, a part of the first sinker is positioned laterally inside the buried layer and is in contact with the buried layer and a further part of the first sinker is positioned laterally outside of the buried layer to increase the breakdown voltage. This part of the first sinker that is positioned laterally outside of the buried layer provides the breakdown influencing structure. The part of the first sinker that is positioned laterally outside of the buried layer is not in direct contact with the buried layer may be used to provide the isolation structure of the semiconductor device with a higher breakdown voltage. The path of the first sinker crosses the lateral extent of the buried layer. This increase in breakdown voltage can be achieved with only a modification of the masks used to form the buried layer and sinker.

In some embodiments, a first section of the first elongate sinker overlaps the buried layer and a second section of the first elongate sinker is arranged laterally adjacent the buried layer. This second section, which is arranged laterally adjacent the buried layer, provides the breakdown influencing structure. In this embodiment, the breakdown voltage influencing structure is integral with the first elongate sinker. The second section is arranged laterally outboard of the lateral extent of the buried layer and the first section laterally inboard of the lateral extent of the buried layer. The first elongate sinker, therefore, crosses the boundary defining the lateral extent of the buried layer.

In some embodiments, at least one sinker is completely inside the lateral extent of the buried layer. This embodiment may be used to achieve the lowest ohmic connection between the sinker and the buried layer.

In some embodiments, the buried layer has a polygonal form in plan view with at least three corners and the second section of the first elongate sinker is arranged laterally adjacent at least one of the corners. The second section of the first elongate sinker is laterally spaced apart from the buried layer, whereas the first section of the elongate sinker overlaps the buried layer. The second section of the first elongate sinker is positioned laterally outside of the first device region and the first section laterally inside the first device region, where laterally denotes a direction parallel to the first major surface. The second section serves to increase the breakdown voltage of the isolation structure at the corner so that the breakdown voltage along the periphery of the first device region is more uniform. This may assist in preventing premature breakdown at the corners of the buried layer.

One such first elongate sinker may be provided for each corner. In other words, a plurality of discrete separate first sinkers is provided for a single buried layer which are spaced apart around the periphery of the buried layer. In other embodiments a single continuous first elongate sinker is provided that has one second section positioned laterally outside of the buried layer at each of the corners. The intervening straight sections of the first sinker are positioned inside the area of the buried layer and are in contact with the buried layer.

In some embodiments, the breakdown voltage influencing structure of the semiconductor device further comprises a third elongate sinker which extends from the first surface to the buried layer and which is in electrical contact with the buried layer. The third elongate sinker may comprise the second conductivity type.

The third elongate sinker may be positioned laterally inside the first elongate sinker and closer to the centre of the first device region. In some embodiments, the third elongate sinker has a continuous ring form and laterally and continuously surrounds the device region. In this embodiment, the third sinker continuously electrically contacts the buried layer. The first elongate sinker may be positioned laterally outboard of the third elongate sinker and spaced apart from the third elongate sinker. In some embodiments comprising a continuous ring-shaped third sinker, one first elongate sinker is provided for each corner of the buried layer and has substantially the same relationship to its respective corner according to one of the embodiments described below.

In some embodiments, the breakdown voltage influencing structure has a continuous ring form and laterally surrounds the first device region. The breakdown influencing structure may comprise one or more of the buried regions, the second sinker, the first sinker structure with its distal ends and the third sinker structure.

In some embodiments, the second section of the first elongate sinker forms a central section of the first elongate sinker and the central section of the first elongate sinker is arranged laterally adjacent and spaced apart from buried layer. The first central section is positioned laterally outside of the buried layer. The first central section of the elongate sinker comprises two distal end sections, each distal end section being positioned on an opposing end of the central section. Each distal end section overlaps the buried layer and inside the lateral extent of the buried layer. The distal end sections may be positioned laterally adjacent and spaced apart from the third elongate sinker by a distance which is less than the distance between the central section and the third elongate sinker. The distal end sections are in electrical contact with the buried layer.

In some embodiments, an end face of the distal end set each of the distal end section is arranged substantially perpendicular to the third elongate sinker. In other embodiments, each of the distal end section has an outermost or end section that extends substantially parallel to the third elongate sinker.

In some embodiments, the first elongate sinker has a continuous ring form and laterally surrounds the first device region. In some embodiments, both the first and third elongate sinker have a continuous ring form and laterally surround the first device region, whereby the first elongate sinker is arranged laterally outboard from the third elongate sinker. In some embodiments, the first, second and third elongate sinkers each have a continuous ring form and laterally and continuously surround the first device region with the second elongate sinker arranged laterally outboard of the third elongate sinker and the first elongate sinker being arranged laterally outboard of the second elongate sinker such that the second elongate sinker is arranged between the first and third elongate sinkers.

The first elongate sinker, second elongate sinker and third elongate sinker, if used, may have different forms. Each of the first, second and third sinkers may have the same form or may have differing forms. In some embodiments, the first elongate sinker and/or the second elongate sinker and/or the third elongate sinker comprises a trench extending from the first surface into the semiconductor substrate. The trench is filled with material, e.g. n-doped BSG (Boro Silicate Glass) or PSG (Phospho Silicate Glass) or undoped glasses or other insulators.

In some embodiments, the doped BSG or PSG material is subjected to heat to cause outdiffusion of dopants from the BSG or PSG and form a doped region in the semiconductor substrate adjacent the trench. This doped region forms a sinker region. The doped region may be of the second conductivity type. The BSG or PSG material is later removed and the trench is filled with a layer or multiple layers formed or one or more of an undoped oxide, a nitride, polysilicon, silicon, a silicide, a metal or a cavity. In these embodiments, in the final semiconductor device, the trench may comprise an electrically insulating structure and the sinker (the first elongate sinker and/or the second elongate sinker and/or the third elongate sinker as the case may be) is formed by the doped region of the second conductivity type arranged in the semiconductor substrate laterally adjacent to the trench.

In other embodiments, the first elongate sinker and/or the second elongate sinker and/or the third elongate sinker comprise a region of the semiconductor substrate that is doped with dopants of the second conductivity type. This structure may be formed by implantation of the dopants into the substrate may means of a mask having one or more openings having a form corresponding to the desired lateral shape of the respective sinker in the semiconductor substrate, the dopants being implanted though the opening(s) through which the dopants are implanted.

In some embodiments, the second elongate sinker and the buried region are electrically floating.

In some embodiments, the buried layer has a doping profile with a central maximum region and tail regions, the central maximum region laterally extending into tail regions which have a doping level that decreases as a function of lateral distance from the central maximum region. The tail regions are situated at the lateral edge of the buried layer. The breakdown voltage influencing structure may also have a doping profile with a maximum region and tail regions, the central maximum region laterally extending into tail regions which have a doping level that decreases as a function of lateral distance from the central maximum region. The tail regions are situated at the lateral edge of the breakdown influencing structure, for example the lateral edge of the first sinker, the buried region or the second sinker or the third sinker if used.

In the case of a trench that is filled or lined with an oxide, outdiffusion from the sidewalls leads to the formation of a doping profile with two maxima without a constant region and there is a one-sided outdiffusion from each of the two maxima.

In some embodiments, the buried layer has a doping profile with a central maximum region and tail regions and the breakdown voltage influencing structure comprises one or more trenches which are lined with an oxide and optionally doped polysilicon. The polysilicon may be n-doped or p-doped. The breakdown influencing structure further comprises a doped sinker region adjacent the trench. The tail region of the buried layer overlaps with the doped sinker region of the breakdown voltage influencing structure in regions in which the breakdown influencing structure is arranged laterally adjacent the buried layer and/or the maximum region of the breakdown voltage influencing structure overlaps the maximum region of the buried layer in regions in which the breakdown voltage influencing structure is in electrical contact with the buried layer.

The doped sinker region may be formed by the earlier outdiffusion of dopants from material within the trench. This material may have been removed after the outdiffusion and then the oxide and doped polysilicon formed in the trench.

In some embodiments, the tail region of the buried layer overlaps with the tail region of the breakdown voltage influencing region in one or more locations in which the breakdown voltage influencing structure is arranged laterally adjacent the buried layer.

In some embodiments, at least a part of the maximum region of breakdown voltage region overlaps at least a part of the maximum region of the buried layer in regions in which the breakdown voltage influencing structure is in electrical contact with the buried layer.

The resistance of the electrical contact between the breakdown voltage influencing structure and the buried layer may be adjusted by adjusting the overlap of the doping profiles. For example, in order to decrease the electrical resistance, the maximum doping region of the breakdown voltage influencing region is arranged so as to overlap the maximum region of doping region of the buried layer. In other regions, in which a more resistive or no electrical contact is desired, the tail region of the breakdown voltage influencing region, which has a lower doping concentration, is adjusted so as to overlap with the tail region of the buried layer that has a lower doping concentration.

In some embodiments, the decrease, dD/dx, in the doping concentration of the tail region of the first sinker is greater than the decrease, dD/dx, in the doping concentration of the tail region of the buried layer. In these embodiments, the tail region of the first sinker has a smaller lateral extent than the tail region of the buried layer.

In some embodiments, the height of the buried layer, the height being defined by the vertical distance between the upper pn junction formed between the buried layer and the semiconductor substrate and the lower pn junction formed between the buried layer and the semiconductor substrate, is at least twice or at least three times or at least four times the width of the first sinker, the width being defined as the lateral distance between the opposing pn junctions formed between the first sinker and the semiconductor substrate.

A first semiconductor device may be arranged in the first device region and a second semiconductor device is arranged in the semiconductor substrate laterally adjacent to the first device region. The semiconductor substrate may include one or more second device regions and the second semiconductor device(s) are arranged in the second device region(s).

For example, the first semiconductor device may be a gate driver, for example a gate driver for high side switch of the half bridge circuit, and the second semiconductor device may be gate driver for the low side switch of the half bridge circuit. In other embodiments, the first semiconductor device may be a logic device and the second semiconductor device may be a power device, for example a power transistor device.

More than one semiconductor device may be arranged in the second device region of the semiconductor substrate. For example, two power transistor devices that electrically connected to form half bridge circuit along with the gate driver for the low side switch of the half bridge circuit may be arranged in the second device region of the semiconductor device and the gate driver for the high side switch of the half bridge circuit may be arranged in the first device region which is electrically separated from the semiconductor substrate by the isolation structure. More than one device may be arranged in the first device region. The semiconductor substrate may also include more than one first device region, each of which is electrically separated from the semiconductor substrate by an isolation structure according to any one of the embodiments described herein.

Those skilled in the art will recognize additional features and advantages upon reading the following detailed description, and upon viewing the accompanying drawings.

### BRIEF DESCRIPTION

The elements of the drawings are not necessarily to scale relative to each other. Like reference numerals designate corresponding similar parts. The features of the various illustrated embodiments can be combined unless they exclude each other. Exemplary embodiments are depicted in the drawings and are detailed in the description which follows.
Figure 1, which includes figures 1A to 1D, illustrates a semiconductor device according to an embodiment.
Figure 2 illustrates a portion of a semiconductor device according to an embodiment.
Figure 3 illustrates a portion of a semiconductor device according to an embodiment.
Figure 4 illustrates a portion of a semiconductor device according to an embodiment.
Figure 5 illustrates a portion of a semiconductor device according to an embodiment.
Figure 6 illustrates a portion of a semiconductor device according to an embodiment.
Figure 7 illustrates a portion of a semiconductor device according to an embodiment.

### DETAILED DESCRIPTION

In the following detailed description, reference is made to the accompanying drawings, which form a part hereof, and in which is shown by way of illustration specific embodiments in which the invention may be practiced. In this regard, directional terminology, such as "top", "bottom", "front", "back", "leading", "trailing", etc., is used with reference to the orientation of the figure(s) being described. Because components of the embodiments can be positioned in a number of different orientations, the directional terminology is used for purposes of illustration and is in no way limiting. It is to be understood that other embodiments may be utilized and structural or logical changes may be made without departing from the scope of the present invention. The following detailed description, thereof, is not to be taken in a limiting sense, and the scope of the present invention is defined by the appended claims.

A number of exemplary embodiments will be explained below. In this case, identical structural features are identified by identical or similar reference symbols in the figures. In the context of the present description, "lateral" or "lateral direction" should be understood to mean a direction or extent that runs generally parallel to the lateral extent of a semiconductor material or semiconductor carrier. The lateral direction thus extends generally parallel to these surfaces or sides. In contrast thereto, the term "vertical" or "vertical direction" is understood to mean a direction that runs generally perpendicular to these surfaces or sides and thus to the lateral direction. The vertical direction therefore runs in the thickness direction of the semiconductor material or semiconductor carrier.

As employed in this specification, when an element such as a layer, region or substrate is referred to as being "on" or extending "onto" another element, it can be directly on or extend directly onto the other element or intervening elements may also be present. In contrast, when an element is referred to as being "directly on" or extending "directly onto" another element, there are no intervening elements present.

As employed in this specification, when an element is referred to as being "connected" or "coupled" to another element, it can be directly connected or coupled to the other element or intervening elements may be present. In contrast, when an element is referred to as being "directly connected" or "directly coupled" to another element, there are no intervening elements present.

As used herein, various device types and/or doped semiconductor regions may be identified as being of n type or p type, but this is merely for convenience of description and not intended to be limiting, and such identification may be replaced by the more general description of being of a "first conductivity type" or a "second, opposite conductivity type" where the first type may be either n or p type and the second type then is either p or n type.

The Figures illustrate relative doping concentrations by indicating "-" or "+" next to the doping type "n" or "p". For example, "n⁻" means a doping concentration which is lower than the doping concentration of an "n"-doping region while an "n⁺"-doping region has a higher doping concentration than an "n"-doping region. Doping regions of the same relative doping concentration do not necessarily have the same absolute doping concentration. For example, two different "n"-doping regions may have the same or different absolute doping concentrations.

A semiconductor device including a device region that is electrically separated from the semiconductor substrate by an isolation structure is provided. One or more first semiconductor devices may be formed in the first device region and one or more second semiconductor devices may be formed in the remainder of the semiconductor substrate. The first device(s) in the first device region are electrically separated from the semiconductor substrate by way of the isolation structure. A breakdown influencing structure is provided in the semiconductor substrate laterally outside of the device region that serves to locally increase the breakdown voltage of isolation structure to improve the reliability of the semiconductor device. This enables the semiconductor substrate to be used for devices having a higher operating voltage.

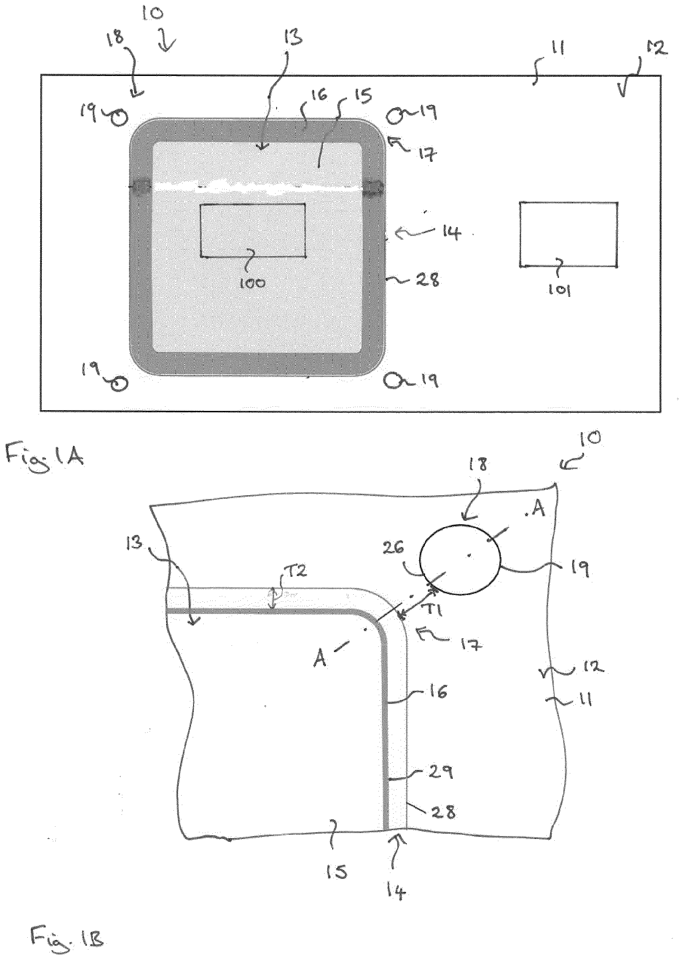

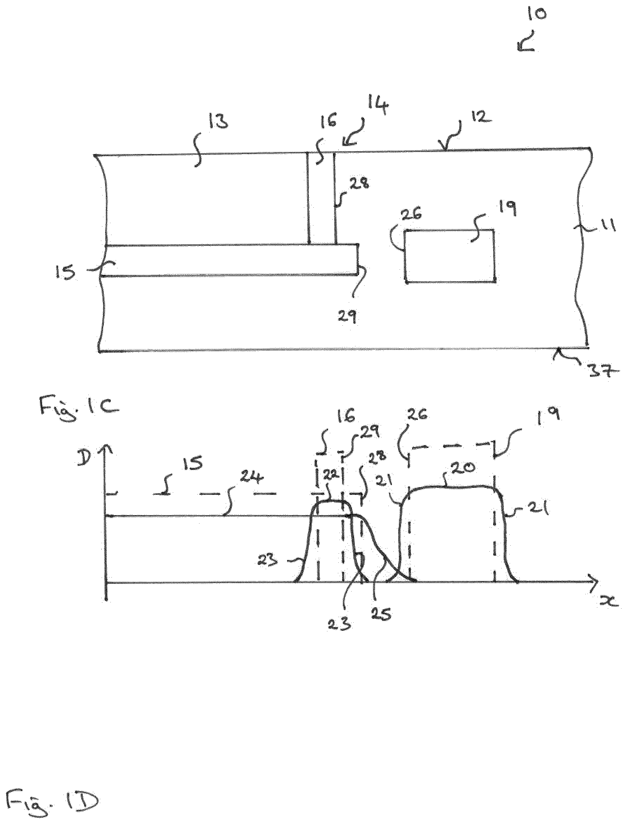

Figure 1 includes figures 1A to 1D illustrates various views of a semiconductor device 10 according to an embodiment, whereby figure 1A illustrates a top view of the semiconductor device 10, figure 1B illustrates an enlarged view of a portion of figure 1A, figure 1C illustrates a cross-sectional view of a figure 1B along the line A-A and figure 1D illustrates a graph of the doping concentration in the semiconductor substrate for the cross-sectional view of figure 1C.

The semiconductor device 10 comprises a semiconductor substrate 11 of the first conductivity type that comprises a first surface 12. The semiconductor substrate 11 may be formed of silicon, for example an epitaxially deposited silicon layer formed on monocrystalline silicon. The first conductivity type may be p type. The semiconductor device 10 comprises a first device region 13 which is formed in the semiconductor substrate 11 and also has first conductivity type. The first device region 13 has a lateral extent that is less than the lateral extent of the first surface 12 of the semiconductor substrate 11. Lateral refers to directions in a plane that is parallel to the first major surface 12 of the semiconductor substrate 11.

The first device region 13 is electrically separated from the remainder of the semiconductor substrate 11 by an isolation structure 14 The isolation structure 14 comprises a buried layer 15 which is doped with the second conductivity type that opposes the first conductivity type. For example, if the first conductivity type is p type, the buried layer 15 is n-type. The buried layer 15 is positioned within the semiconductor substrate 11 and is spaced part from the first major surface 12 and the opposing second major surface 37 of the semiconductor substrate 11 by portions of the material of the semiconductor substrate 11. The buried layer 15 has a certain height and depth from the first major surface 12 and is surrounded above and below as well as laterally by material of the first semiconductor substrate 11. The buried layer 15 has a substantially square-shape and has four corners 17 which, in this embodiment, are rounded.

The isolation structure 14 further comprises a first elongate sinker 16 of the second conductivity type which, as can be seen from the cross-sectional view of figure 1C, extends from the first surface 12 into the semiconductor substrate 11. The first elongate sinker 16 is in electrical contact with the buried layer 15. In some embodiments, such as that illustrated in figure 1, the first sinker 16 has a continuous ring shape, particular a substantially square ring-shape with curved corners. The first sinker 16 extends at least to and may have a base positioned in the buried layer 15. In some embodiments, the buried layer 15 extends laterally outwardly from the first elongate sinker 16 such that the elongate first elongate sinker 16 continuously overlaps with the buried layer 15. The first elongate sinker 16 may be laterally inwardly offset from the outermost lateral extent of the buried layer 15 by a distance. The distance T2 between the outwardly facing side wall 29 of the first sinker 16 and the edge 28 of the buried layer 28 may be, for example, a few microns.

The first device region 13 is bounded continuously on all sides by the first elongate sinker 16 and is electrically separated from the remainder of the semiconductor substrate 12 by means of the isolation structure 14 provided by the buried layer 15 and the first elongate sinker 16. The first device region 13 and the semiconductor substrate 1 have the same conductivity type. The first device region 13 can be used for a semiconductor device which in operation is to be at a different potential to the one or more further semiconductor devices which are formed in the semiconductor substrate 11 laterally outside and adjacent to the first device region 13.

In the plan views of figures 1A and 1B, the form of the first elongate sinker 16 and the lateral extent of the buried layer 15 represent the nominal position of the first sinker 16 and buried layer 15 in the semiconductor substrate 11. The form and lateral shape of the first elongate sinker 16 and the buried layer 15 shown in the plan views of figures 1A and 1B also represent a respective opening in a mask which is used to form the respective structure within the semiconductor substrate 11.

The buried layer 15 may be formed by implantation of dopants of the second conductivity type into the first semiconductor substrate 11 through an opening in a mask, the opening having the square form shown in figure 1A. An outdiffusion and an epitaxial overgrowth may follow. The first elongate sinker 16 may also be formed by implantation of dopants of the second conductivity type into the first surface 12 of the semiconductor substrate 11 through an opening in a mask, the opening having the square ring form shown in figure 1A. An outdiffusion may follow as well as an epitaxial overgrowth. These steps can even be repeated several times.

Alternatively, the first elongate sinker 16 may be formed by a trench which is formed in the first major surface 12 of the semiconductor substrate and which extends into the semiconductor substrate 11 such that it has a base which is in contact with or positioned within the buried layer 15. The trench is then filled or lined with material containing dopants which will form a region of the second conductivity type e.g. after outdiffusion. For example, the trench may be filled with PSG which itself is not electrically conductive. Only after the outdiffusion, it the region of the semiconductor substrate, e.g. Si, electrically conductive. The trench may be formed by etching using a mask having an opening with the square ring form shown in figure 1A. The material filling or lining the trench may be removed and the trench may then be filled or lined with an insulator or a conductive material or stacks of these materials.

The semiconductor device 10 further comprises a breakdown voltage influencing structure 18 of the second conductivity type which is arranged in the semiconductor substrate 11 and laterally adjacent the buried layer 15 and also laterally adjacent the isolation structure 14 of the first device region 13. The breakdown voltage influence in structure 18 is, therefore, positioned laterally outside or outboard of the lateral extent of the buried layer 15 and of the first device region 13 and within the semiconductor substrate 11. The breakdown influencing structure 18 may be laterally spaced apart from the buried layer 15 by an intervening portion of the semiconductor substrate 11.

The isolation structure 14 may have a breakdown voltage that locally varies. For example, the breakdown voltage may be lower at the corners 17 of the buried layer 15 and of the first device region 13 than at the straight sides 28 of the buried layer 15 and of the first device region 13. The breakdown influencing structure 18 may have a form and position in the semiconductor substrate so as to provide a breakdown voltage that is more uniform around the isolation structure, for example so as to locally raise the breakdown voltage at the corners 17 relative to the breakdown voltage of the straight sides 28 of the first device region 13. In some embodiments, a discrete or separate breakdown voltage influencing structure 18 may be positioned laterally adjacent each of the corners 17 of the first device region 13.

In some embodiments, such as that illustrated in figure 1, the breakdown voltage influencing structure 18 has the form of a buried region 19 of the second conductivity type which is positioned within the semiconductor substrate 11. Referring to figure 1C, the buried region 19 may be positioned at a depth from the first major surface 12 which is similar to the depth of the buried layer 15 from the first major surface 12. The buried region 19 is spaced apart from the buried layer 15 and first sinker 16 and is electrically floating. The buried region 19 is spaced apart from the buried layer 15 by a distance T1 which is the smallest distance between the side face or edge 28 of the buried layer 15 and the side face or edge 26 of the buried region 19. The buried region 19 may have a height which is greater than the height of the buried layer 15 and be positioned such that it vertically overlaps the entire thickness of the buried layer 15.

In this embodiment, one buried region 19 is arranged laterally adjacent each of the four corners 17 of the isolation structure 14 of the first device region 13. In some embodiments, the buried region 19 may have the form of the discrete bubble and may have different forms in plan view. In the embodiment illustrated in figure 1, the buried region 19 has an oval or substantially circular form. In other embodiments, the buried region 19 may have an elongate form, a curved form or a stripe-like form in plan view. The buried region 19 is not limited to having a position adjacent the corner 17 of the buried layer 15 but may also have an elongate shape and extend substantially parallel to the straight side face 28 of the doped buried layer 15 or may have a curved form extending around the corner 17.

During manufacture of the semiconductor device, the semiconductor substrate 11 is subjected to heat to activate the dopants of the second conductivity type which can cause diffusion of the dopants within the buried layer 15, the first sinker structure 16 and the buried region 19. This results in a structure within the semiconductor device 10 which differs from the schematic view illustrated in figure 1C which shows the nominal boundaries of these structures. Due to the subsequent outdiffusion and, in particular, lateral diffusion from the implanted regions the lateral extent of the feature may differ from, e.g. be greater than, the nominal extent. Consequently, the plan views of the semiconductor devices 10 shown herein depict idealised arrangements of the nominal structures. The depicted arrangements also correspond to the opening in the masks used to fabricate the semiconductor device. In some embodiments, after the outdiffusion of dopants from the buried layer 15 and the buried region 19, an epitaxial semiconductor layer is formed on top. The trench 28 for the sinker structure 16 is then formed, for example by etching in this epitaxial semiconductor layer.

Figure 1D illustrates a diagram of the doping profile of the structure illustrated in figure 1C and shows the doping concentration D as a function of lateral position x. Figure 1D indicates the nominal position of the buried region 19, the buried layer 15 and first sinker 16 by dashed lines. Referring to the buried region 19, the buried region 19 has a doping profile having a maximum region 20 towards the centre and tail regions 21 extending laterally outwards in which the doping concentration D of the second dopant type decreases. Similarly, the first sinker 16 has a doping profile having a maximum doping concentration region 22 that decreases in tail regions 23.

The doping profile of the buried layer 15 also has a maximum doping concentration region 24 and tail regions 25 which extends laterally outwardly from the maximum region 24. The decrease, dD/dx, in the doping concentration of the first sinker 16 in the tail region 23 is greater than the decrease in the doping concentration of the tail region 25 of the buried layer 15. Consequently, the tail region 23 of the first sinker 16 has a smaller lateral extent than the tail region 25 of the buried layer 15.

Referring to figures 1C and 1D, in some embodiments, the maximum region 20 of the doping profile of the buried region 19 and the maximum region 22 of the doping profile of the first sinker 16 are spaced apart from one another. The tail region 23 of the doping profile of the first sinker 16 and the tail region 21 of the buried region 19 may also be spaced laterally spaced apart from one another or may overlap, as shown in the example of figure 1D.

In embodiments in which the material in the trench, for example PSG, serves as a dopant source which is subsequently removed, the doping profile in the trench region is zero so that only the tail region 23 is observable in the semiconductor device 10.

The nominal spacing, T2, between the buried layer 15 and the first sinker 16 and the nominal spacing, T1, between the buried layer 15 and the buried region 19 may be adjusted so as to increase or decrease the amount of overlap in the doping profiles. For example, in order to provide a good electrical contact between the first sinker 16 and the buried layer 15, the maximum region 22 of the first sinker 16 may entirely overlap with the maximum region 24 of the doping profile of the buried layer 15. Figure 1 illustrates an example of this arrangement. In embodiments in which the material in the trench, for example PSG, serves as a dopant source which is subsequently removed, only the tail region 23 overlaps with the maximum region 24 of the doping profile of the buried layer 15 in the semiconductor device 10.

The resistance of the electrical contact can be reduced and the breakdown voltage of the isolation structure 14 increased by increasing the spacing between the nominal positions of the first sinker 16 and buried layer 15 such that the maximum regions only partly overlap or such that a smaller portion of the tail regions overlap or such that there is no overlap of the tail regions. The breakdown voltage of the isolation structure 14 may be optimised by adjusting the spacing between the nominal positions of the buried layer 15 and the buried region 19 such a smaller portion of the tail regions overlap or such that there is no overlap of the tail regions. Thus, the influence of the breakdown influencing structure 18 on the breakdown voltage of the isolation structure 14 can be adjusted by adjusting the relative positions, for example by adjusting the relative positions of the openings in the masks. In addition to the spacings of the openings used in the masks, the doping profile may be adjusted by adjusting the doping concentration, for example by adjusting the implantation conditions, for example, the implantation energy, and/or the subsequent post implantation annealing conditions.

In an embodiment, a n-buried layer 15 and the buried region 19 is implanted into a low doped p-substrate 11 e.g. with an Arsenic or Antimony dose of 1 e15 to 1e16cm⁻² with an energy of 20 to 100keV + Phosphorus dose of 1e13 to 1e14cm⁻² with an energy of >500keV and a drive in of around 60 to 600min plateau time at 1100 to 1250°C is used. The buried region 19 may be formed at the same time as the n-buried layer 15. Then a low doped p-epi layer 11 is deposited, the sinker trench for the first sinker 16 is etched and PSG is deposited on the trench side walls followed by a drive-in with e.g 900 to 1100°C 30 to 300min. Other temperature processes with lower temperature may follow. The n-buried layer15 therefore exhibits laterally a smooth concentration drop while the n-sinker 16 exhibits a much steeper drop. This results in a different optimization of buried layer 15 and first sinker 16 position: Dependent on the relative position and overlap between the buried layer 15 and first sinker 16, the relationship between the lowest ohmic contact and the highest breakdown voltage can be adjusted.

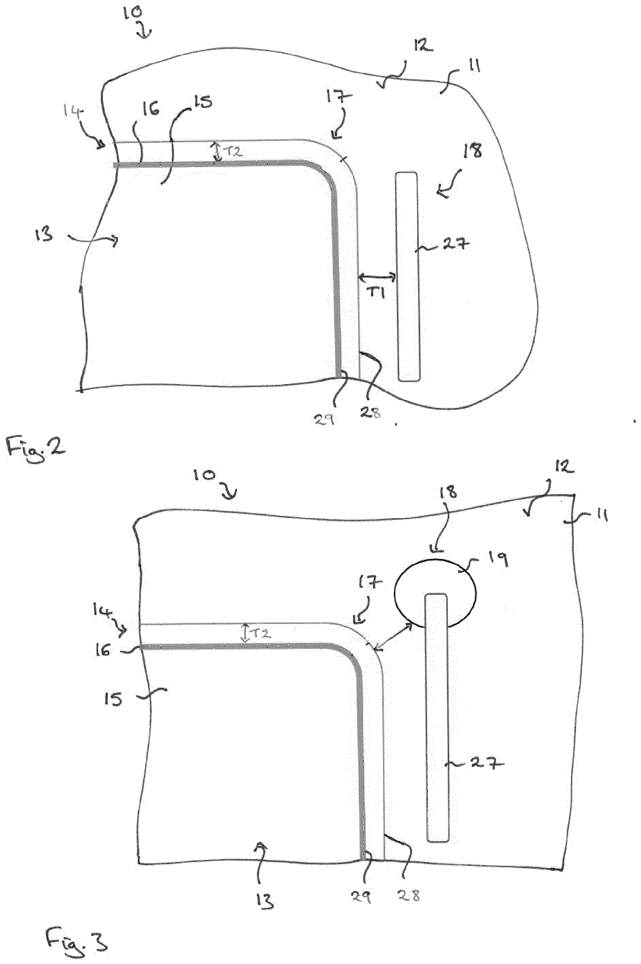

The breakdown voltage influencing structure 18 may have different forms and is not limited to the doped buried region 19 illustrated in figure 1. Alternative arrangements for providing a breakdown voltage influencing structure 18 are illustrated in figures 2 to 7. The relative positions and position of lateral boundaries of the features described below refer to the nominal position and lateral boundary of the respective features and also depict the openings in the respective masks used to form the respective feature.

Referring to figure 1A, a first semiconductor device 100 may be formed in the first device region and one or more semiconductor devices 101 may be formed in the semiconductor substrate 11 laterally adjacent to and laterally outside of the first device region 13. The first semiconductor device 100 may be a gate driver, for example a gate driver for high side switch of the half bridge circuit, and the second semiconductor device 101 may be gate driver for the low side switch of the half bridge circuit. In other embodiments, the first semiconductor device 100 may be a logic device and the second semiconductor device 101 may be a power device, for example a power transistor device.

In some embodiments, three semiconductor devices 101 are arranged in the semiconductor substrate 11 laterally adjacent to and laterally outside of the first device region 13. Two power transistor devices that electrically connected to form half bridge circuit and providing the high side switch and the low side switch of the half bridge circuit and a gate driver for the low side switch of the half bridge circuit may be arranged in the semiconductor device and the gate driver 100 for the high side switch of the half bridge circuit may be arranged in the first device region 13 which is electrically separated from the semiconductor substrate 11 by the isolation structure 14.

Figure 2 illustrates a portion of a plan view of a semiconductor device 10 which differs from that illustrated in figure 1 by the form of the voltage breakdown voltage influencing structure 18. In this embodiment, the voltage breakdown voltage influencing structure 18 has the form of a second sinker 27 which is arranged in the semiconductor substrate laterally adjacent and outside of the first device region and spaced apart from the edge 28 of the buried layer 15. The first sinker 16 and buried layer 15 of the isolation structure 14 have the same form as that illustrated in figure 1. The first sinker 16 has a continuous square ring-shape is positioned within and overlaps and electrically contacts the buried layer 15 along its entire length.

In this embodiment, the second sinker 27 has an elongate stripe -like structure and extends substantially parallel to the straight side face 28 of the buried layer 15 and a straight side face 29 of the first sinker 16. The second sinker 27 may have the form of a region of the semiconductor substrate 11 which is doped with the second conductivity type or may have the form of a trench formed in the semiconductor substrate 11 which extends into the semiconductor substrate 11 from the first major surface 12 and which is filled with material doped with the second conductivity type.

The second sinker 27 extends from the first major surface 12 into the semiconductor substrate 11 to a depth which is substantially the same as or greater than the depth of the buried layer 15 from the first major surface 12. The second sinker 27 has a length and is arranged in the semiconductor substrate 11 such that it is not positioned adjacent the corner 17 of the doped buried layer 15. The spacing T1 between the second sinker 27 and the edge 28 of the buried layer 15 may be adjusted to adjust the breakdown voltage of the isolation structure 14.

Figure 3 illustrates a portion of a plan view of a semiconductor device 10 which differs from that of figures 1 and 2 in that the breakdown voltage influencing structure 18 comprises the second sinker 27 and the doped buried region 19. The doped buried region 19 is arranged laterally adjacent the corner 17 of the buried layer 15 of the device region 13 and is substantially coplanar with the buried layer 15 as in the embodiment illustrated in figures 1A to 1D. The second sinker 27 extends from the first major surface 12 into the semiconductor substrate 11 and parallel to side face 28 of the buried layer 15. The second sinker 27 has a length such that it is positioned adjacent the corner 17 and overlaps with the buried region 19. The second sinker 27 has a depth such that its base is arranged in and is in electrical contact with the buried region 19. The buried region and second sinker 27 are electrically floating. One structure comprising a buried region 19 and second sinker 27 may be arranged at each of the four corners 17 of the isolation structure 14. The spacing between the combined structure and the isolation structure 14 and the overlap between the buried region 19 and second sinker 27 may be adjusted so as to locally adjust he breakdown voltage of the isolation structure.

The buried region 19 is not limited to having a position adjacent the corner 17 of the buried layer 15 but may also have an elongate shape and extend substantially parallel to the side face 17 of the doped buried layer 15 or may have a curved form extending around the corner 17. The buried region 19 and the second sinker 27 may also have substantially the same shape. However, the buried region 19 may be broader than the second sinker 27.

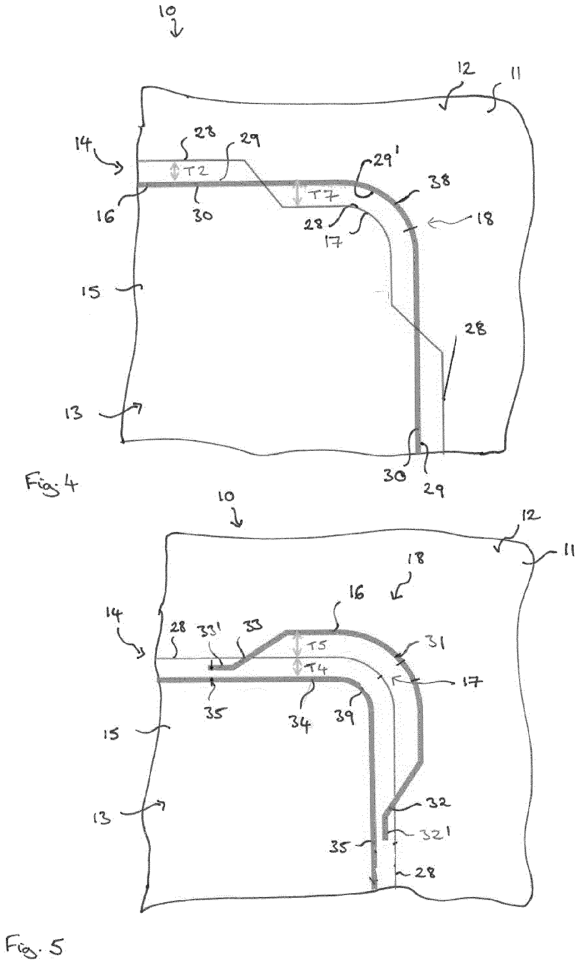

Figure 4 illustrates a portion of a plan view of a semiconductor device 10 which comprises a first device area 13, which is electrically separated from the semiconductor substrate 11 by an isolation structure 14, and a breakdown voltage influencing structure 18.

In this embodiment, the first elongate sinker 16 has a substantially square or rectangular ring-form, whereby the corners 38 of the square or rectangle, of which one is illustrated in figure 4, are curved. The curved corner 38 of the first elongate sinker 16 forms a central section of the first elongate sinker 16 which extends into two opposing adjoining straight sections 30.

In the semiconductor device 10 illustrated in figure 4, the curved section 38 of the first sinker 16 is positioned laterally adjacent and laterally outside of the buried layer 13 and first device region 13. This section 38 of the first sinker 16 does not overlap and is not positioned within the lateral extent of the buried layer 15. However, figure 4 may illustrate the mask design. After outdiffusion of the section 38 of the first sinker 16 the latter may overlap with the lateral extent of the buried layer 15. This section 38 of the first sinker provides a breakdown voltage influencing structure 18. In this embodiment, the breakdown voltage influencing structure 18 is integral with the first sinker 16 and integral with the isolation structure 14.

The shape of the buried layer 15 in plan view differs from that shown in figure 1. The buried layer 15 has lateral extent such that its corner region 17 is positioned laterally spaced apart and inboard of the curved corner 38 of the first elongate sinker 16. In board refers to a direction towards the centre of the first device region 13 and towards the centre of the buried layer 15. The buried layer 15 has a lateral extent such that it is positioned laterally outboard of the two adjoining straight sections 30 of the first elongate sinker 16. The buried layer has straight sections 28 that are positioned laterally outboard and substantially parallel to respective straight sections 30 of the first elongate sinker 16. At least a part of the straight sections 30 of the first elongate sinker 16 are positioned within and overlap the buried layer 15. The first elongate sinker 16 can be considered to cross the boundary between the buried layer 15 and the semiconductor substrate 11 and, therefore, the boundary between the first device region 13 and the semiconductor substrate 11. The curved section 38 of the first sinker 38 is positioned in the semiconductor substrate 11 laterally outside of the first device region 13 and the straight sections 30 are arranged laterally within the device region 13.

There is a lateral offset T2 between the outer side face 29 of the inboard straight section 30 of the elongate sinker 16 and the edge 28 of the buried layer 15. There is a lateral offset T7 between the inner side face 29' of the curved section 38 of the first elongate sinker 16 and the edge 28 of the buried layer 15. T2 and T7 may be substantially the same.

As discussed above, the shape and relative positions of the buried layer 15 and the first elongate sinker 16 illustrated in figure 4 are the nominal positions as represented by the openings in the masks used for fabricating the first elongate sinker 16 and the buried layer 15 in the semiconductor substrate 11.

In some embodiments, the elongate sinker 16 also overlaps the buried layer 15 in the corner 17. This arrangement may also be used in the embodiments illustrated in figures 5, 6 and 7. In these embodiments, T7 can be considered to be "negative".

Figure 5 illustrates a portion of a semiconductor device 10 according to another embodiment. Referring to figure 5, the buried layer 15 has a substantially square or rectangular form, whereby the corners 17 are rounded as in the embodiments illustrated in figures 1 to 3. The first elongate sinker 16 does not have a continuous ring-shaped form but has a length such that it is positioned around only one of the corners 17 of the buried layer 15. Four such first elongate sinkers 16 are provided, one for each corner 17, which are laterally spaced apart from one another. In this embodiment, the breakdown voltage influencing structure 18 comprises the first sinkers 16.

The first elongate sinker 16 has a central section 31 which is positioned laterally outboard of the buried layer 15 and which has distal end sections 32, 33 extending from opposing ends of the central section 31. The distal ends sections 32, 33 extend inwardly such that the distal end section 32, 33 is positioned laterally within the area of the buried layer 15 and inboard of the edge 28 of the buried layer 15. At least a part of the distal end sections 32, 33 vertically overlaps and is electrically connected to with the buried layer 15. The distal ends 32, 33 cross the edge 28 of the buried layer 15. In this embodiment, the distal end sections 32, 33 have an outermost section 32', 33', respectively, which extends substantially parallel to the straight side face 28 of the buried layer 15.

In this embodiment, the breakdown voltage influencing structure 18 further comprises a third sinker 34 which has a continuous ring form with straight sections 35 connected by a curved corner section 39. The third sinker 34 is positioned laterally within and inboard of the edge 28 of the buried layer 15. The third sinker 34 overlaps and is in in electrical contact with the buried layer 15. The third elongate sinker 34 may comprise a doped region of the semiconductor substrate 11 which is doped with the second conductivity type and which extends from the first surface 12 into the semiconductor substrate 11 by a depth such that its base touches and overlaps with the buried layer 15. In other embodiments, the third sinker 34 is formed of a trench which is filled with material of the second conductivity type. The third sinker 34 also forms part of the isolation structure 14 for electrically separating the first device region 13 from the semiconductor substrate 11.

In some embodiments, the third sinker 34 is formed by a trench which comprises non-conductive material, e.g. PSG, that either fills or lines the trench serves as a dopant source, but which is subsequently removed. The dopants are outdiffused from this material in the trench to form the third sinker 34 in the form of a doped sinker region of the semiconductive substrate that is arranged adjacent to the trench.

The lateral offset T4 between the third sinker 34 and the edge 28 of the buried layer 15 may be smaller than the offset T5 between the edge 28 of the buried layer 15 and the curved section 31 of the first sinker 31. The outermost distal end sections 32', 33' are positioned laterally between and spaced apart from the third sinker 34 and the edge 28 of the buried layer 15. After outdiffusion, the first sinker 31 may overlap the buried layer 15.

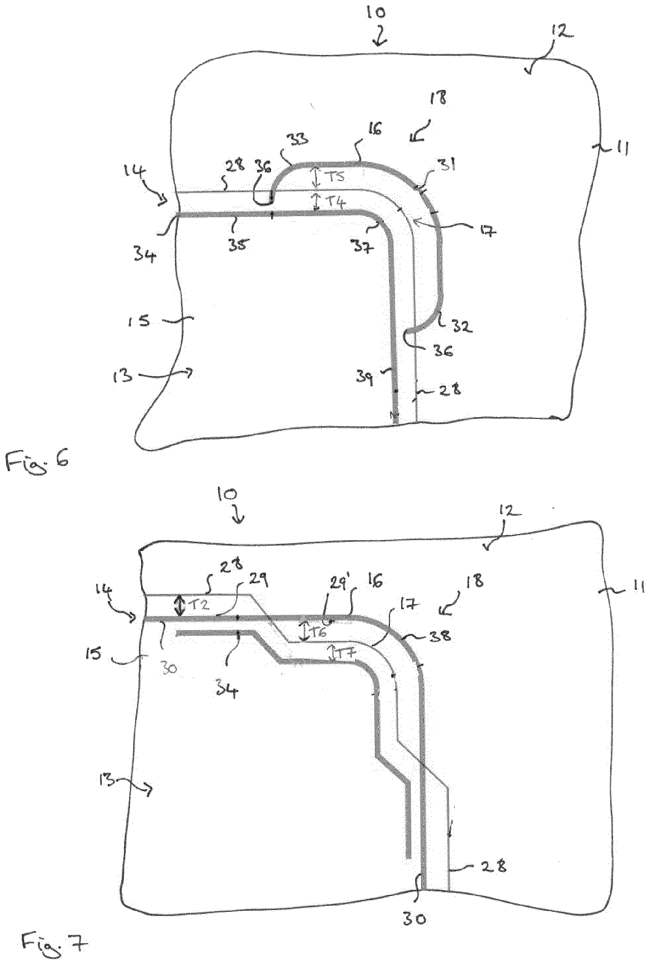

Figure 6 illustrates a plan view of a portion of a semiconductor device 10 showing a portion of the device region 13 and the semiconductor substrate 11 according to an embodiment. The semiconductor device 10 illustrated in figure 6 comprises a substantially square or rectangular buried layer 15 with rounded corners 17, a third elongate sinker 34 having an enclosed ring type shape which is arranged above and in electrical contact with the buried layer 15 and one first elongate sinker 16 arranged at each corner 17 as in the embodiment illustrated in figure 5.

Similar to the design of the first elongate sinker 16 illustrated in figure 5, the first sinker 16 has a central section 31 which is positioned laterally outboard of the buried layer 15 and two distal end sections 32, 33 arranged on opposing sides of the central section 31 which overlap the buried layer 15 The first elongate sinker 16 of the embodiment illustrated in figure 6 differs from that illustrated in figure 5 in that the distal end sections 32, 33 extend substantially perpendicular to the side face 29 of the buried layer 15 and the straight sections 35 of the third elongate sinker 34 such that the end faces 36 of the first sinker 16 face towards the side face 35 of the third elongate sinker 34. At least a part of the distal end sections 32, 33 is positioned within and overlaps the buried layer 15 and is in electrical contact with the buried layer 15.

Figure 7 illustrates a plan view of a portion of the semiconductor device 10 and illustrates a portion of the first device region 13 and the semiconductor substrate 11. The semiconductor device 10 has a first elongate sinker 16 having a continuous ring-shaped form and a buried layer 15 having the shape and arrangement illustrated in figure 4. In this embodiment, the breakdown voltage influencing structure 18 further comprises a third sinker 34 which has a form which is similar to that of the buried layer 15. The third sinker 34 is arranged laterally within the area of the buried layer 15 and inboard of the side face 28 of the buried layer 15. In board refers to a lateral direction towards the centre of the buried layer 15. The third sinker 34 overlaps and is in electrical contact with the buried layer 15. In this embodiment, the third sinker 34 does not form a continuous ring-shaped structure but forms a discrete sinker structure which is positioned around the inboard side of the corner 17 of the buried layer 15. The semiconductor device 10 may include four of the third sinkers 34, one at each corner 17.

In the corner 17 of the buried layer 15, the offset T6 between the laterally outboard section 31 of the first elongate sinker 16 and the edge 28 of the buried layer 15 and the offset T7 between of the third sinker 34 and the edge 28 of the buried layer 15 differs, whereby T7 < T6. Outboard refers to a lateral direction which is further away from the centre of the buried layer 15.

The inboard offset T7 between the third sinker 34 and the edge 28 of the buried layer 15 may be substantially the same throughout the portions in which the central section 38 of the first sinker 16 is arranged laterally outside of the buried layer 15. In the straight sections 30 of the first elongate sinker 16, in which the buried layer 15 is arranged laterally outboard of the first elongate sinker 16 and the first elongate sinker 16 is arranged inboard of the buried layer 15 and overlaps the buried layer 15, the third sinker 34 is arranged adjacent the first elongate sinker 16. In other words, the straight sections 30 of the first elongate sinker 16 are arranged laterally between the third sinker 34 and the edge of the buried layer 15. The distance offset T6 between the edge 28 of the buried layer 15 and the first elongate sinker 16 may be substantially the same in the regions in which the first elongate sinker 16 is arranged laterally inboard and laterally outboard the buried layer 15.

Spatially relative terms such as "under", "below", "lower", "over", "upper" and the like are used for ease of description to explain the positioning of one element relative to a second element. These terms are intended to encompass different orientations of the device in addition to different orientations than those depicted in the figures. Further, terms such as "first", "second", and the like, are also used to describe various elements, regions, sections, etc. and are also not intended to be limiting. Like terms refer to like elements throughout the description.

As used herein, the terms "having", "containing", "including", "comprising" and the like are open ended terms that indicate the presence of stated elements or features, but do not preclude additional elements or features. The articles "a", "an" and "the" are intended to include the plural as well as the singular, unless the context clearly indicates otherwise. It is to be understood that the features of the various embodiments described herein may be combined with each other, unless specifically noted otherwise.

Although specific embodiments have been illustrated and described herein, it will be appreciated by those of ordinary skill in the art that a variety of alternate and/or equivalent implementations may be substituted for the specific embodiments shown and described without departing from the scope of the present invention. This application is intended to cover any adaptations or variations of the specific embodiments discussed herein. Therefore, it is intended that this invention be limited only by the claims and the equivalents thereof.

## Claims

1. A semiconductor device (10), comprising:
a semiconductor substrate (11) of a first conductivity type comprising a first surface (12);
a first device region (13) formed in the semiconductor substrate (11) and having a first conductivity type, wherein the first device region (13) has a lateral extent that is less than a lateral extent of the first surface (12) of the semiconductor substrate (11) and is electrically separated from the semiconductor substrate (11) by an isolation structure (14);
wherein the isolation structure (14) comprises a buried layer (15) doped with a second conductivity type that opposes the first conductivity type and a first elongate sinker (16) of the second conductivity type that extends from the first surface into the semiconductor substrate (11) and that is in electrical contact with the buried layer (15);
a breakdown voltage influencing structure (18) of the second conductivity type that is arranged in the semiconductor substrate (11) and laterally adjacent the buried layer (15).

2. A semiconductor device (10) according to claim 1, wherein the breakdown voltage influencing structure (18) comprises a second sinker (27) of the second conductivity type that extends from the first surface (12) into the semiconductor substrate (11) and is arranged laterally adjacent the buried layer (15)

3. A semiconductor device (10) according to claim 1 or claim 2, wherein the breakdown voltage influencing structure (18) comprises at least one buried region (19) of the second conductivity type that is arranged laterally adjacent the buried layer (15).

4. A semiconductor device (10) according to claim 3, wherein the buried layer (15) has a polygonal form in plan view with at least three corners (17), wherein one of the buried regions (19) is arranged laterally adjacent one of the corners of the buried layer (15).

5. A semiconductor device (10) according to claim 3 or claim 4, wherein the buried region (19) overlaps the second sinker (27).

6. A semiconductor device (10) according to any one of claims 1 to 5, wherein a first section (30) of the first elongate sinker (16) overlaps the buried layer (15) and a second section (38) of the first elongate sinker (16) is arranged laterally adjacent the buried layer (15) and the second section (38) provides the breakdown voltage influencing structure (18).

7. A semiconductor device (10) according to claim 6, wherein the buried layer (15) has a polygonal form in plan view with at least three corners (17) and the second section (38) of the first elongate sinker (16) is arranged laterally adjacent at least one of the corners (17).

8. A semiconductor device (10) according to claim 7, further comprising a third elongate sinker (34) that extends from the first surface (12) to the buried layer (15) and is in electrical contact with the buried layer (15).

9. A semiconductor device (10) according to any one of claims 1 to 8, wherein breakdown voltage influencing structure (18) has a continuous ring form and laterally surrounds the first device region (13).

10. A semiconductor device (10) according to any one of claims 6 to 11, wherein the second section (38) of the first elongate sinker (16) forms a central section (31) of the first elongate sinker (16) that is arranged laterally adjacent the buried layer (15) and the first section (30) of the elongate sinker (16) comprises two distal end sections (32, 33) that overlap the buried layer (15).

11. A semiconductor device (10) according to claim 10, wherein an end face (36) of the distal end sections (32, 33) is substantially perpendicular to the third elongate sinker (34), or the distal end sections (32, 33) have an outermost section (32', 33') that extends substantially parallel to the third elongate sinker (34).

12. A semiconductor device (10) according to any one of claims 1 to 9, wherein the first elongate sinker (16) has a continuous ring form and laterally surrounds the first device region (13).

13. A semiconductor device (10) according to any one of claims 1 to 12, wherein the first elongate sinker (16) and/or the second elongate sinker (27) and/or the third elongate sinker (34) comprises a first trench extending form the first surface into the semiconductor substrate (11) filled or lined with material of the second conductivity type or comprises a doped region of the semiconductor substrate (11) that is doped with dopants of the second conductivity type.

14. A semiconductor device (10) according to any one of claims 1 to 13, wherein the buried layer (15) has a doping profile with a central maximum region (24) and tail regions (25) and the breakdown voltage influencing structure (19) has a doping profile with tail regions (21), wherein the tail region (25) of the buried layer (15) overlaps with the tail region (21) of the breakdown voltage influencing structure (19) in regions in which the breakdown influencing structure (18) is arranged laterally adjacent the buried layer (15) and/or the maximum region (20) of the breakdown voltage influencing structure (19) overlaps the maximum region (24) of the buried layer (15) in regions in which the breakdown voltage influencing structure (19) is in electrical contact with the buried layer (15).

15. A semiconductor device (10) according to any one of claims 1 to 14, further comprising a first semiconductor device (100) arranged in the first device region (13) and a second semiconductor device (101) arranged in the semiconductor substrate (11), wherein the first semiconductor device (100) is a gate driver for a high side switch of a half bridge circuit and the second semiconductor device (101) is a gate driver for a low side switch of a half bridge circuit, or the first semiconductor device (100) is a logic device and the second semiconductor device (101) is a power device.
